# EUROPEAN PATENT SPECIFICATION

(11) **EP 2 812 995 B1**
(45) Date of publication and mention of the grant of the patent: **25.11.2020**
(21) Application number: 13709498.3
(22) Date of filing: 07.02.2013
(51) Int. Cl.: H03G 3/34, H03K 17/16

(54) **AUDIO SIGNAL SWITCHING**
UMSCHALTUNG VON AUDIOSIGNALEN
COMMUTATION DE SIGNAUX AUDIO

(30) Priority: 09.02.2012 GB 201202263
(43) Date of publication of application: 17.12.2014
(73) Proprietor: Soundchip SA, 1030 Bussigny-Près-Lausanne (CH)
(72) Inventor: DARLINGTON, Paul, 1030 Bussigny-près-Lausanne (CH)
(74) Representative: Abraham, Richard
(86) International application number: PCT/GB2013/050281
(87) International publication number: WO 2013/117927

(56) References cited:
- US-A- 5 027 019
- US-A- 5 444 312

## Description

The present invention relates to switching signals and particularly but not exclusively to switching analogue audio signals (e.g. in an audio circuit).

The switching of audio signals within a complex audio system is a familiar problem in analogue electronic design, with the instantaneous transition between "on" and "off' states acting to generate an audible transient at the instant of the transition due to convolution of the spectra of the audio signal and of the switching waveform implementing the transition. So-called "soft switching" - that is, switching audio signals in such a manner as not to generate audible transients, which sometimes are referred to by the onomatopoeic phase "click and pop" - is a required feature of many audio devices.

A complex analogue audio circuit may require soft switching to be implemented in many places within multiple signal paths. Where such a circuit is implemented within a highly integrated architecture, such as a silicon chip or integrated circuit, limitations within the architecture, or limitations imposed through the connectivity which can be achieved through packaging of such highly-integrated assemblies, may make the provision of individual, replicated soft switches inefficient or impracticable.

US 5027019 discloses a circuit in accordance with the pre-characterising portion of claim 1.

The present applicant has identified the need for a way of more efficiently implementing soft switching in a complex circuit in a highly integrated architecture.

In accordance with a first aspect of the present invention, there is provided a circuit (e.g. audio circuit) comprising: first and second switching arrangements, each switching arrangement comprising: a signal input (e.g. analogue signal input); a signal output (e.g. analogue signal output); a switching stage that has a control input, the switching stage being operative, in response to a control signal applied to the control input changing between a first voltage level and a second voltage level, to change between a first state in which it causes a signal on the signal input to pass to the signal output and a second state in which the signal output is muted; and a control stage that operates: in a steady mode to apply a steady signal to the control input of the switching stage at one or other of the first or the second voltage level to cause the switching stage to be maintained in its first or its second state as required; and in a switching mode to apply a universal switching signal that transitions between the first voltage level and the second voltage level (e.g. in a monotonic manner) to the control input of the switching stage to cause the switching stage to transition between its first and its second state; and the circuit further comprising a signal generator configured to provide the universal switching signal to each of the first and second switching arrangements, wherein the control stage of each of the first and second switching arrangements is further configured to cause its respective switching stage to change between its first and its second states in response to control logic specific to each respective switching arrangement, wherein the universal switching signal transitions between the first and the second voltage levels in a period of time that causes each switching stage to change state at a rate that is sufficiently slow as to prevent audible transients appearing on the signal output; characterised in that the universal switching signal is an oscillating signal continuously supplied to the control stage of each of the first and second switching arrangements with the control logic determining when the switching stage of each of the first and second switching arrangements changes between its first and second states using the universal switching signal to effect the change.

In this way, a circuit is provided in which the function of maintaining the output of each switching arrangement in its steady state is separated from the function of transitioning each switching arrangement between its states, the latter being controlled by the universal switching signal. Advantageously, such an arrangement may include just one signal generator that supplies a signal to several or to all of the switching arrangements. In a complex analogue system that includes multiple circuits that must be switched, this can result in a significant reduction in the number of components required to provide implement the switching circuits.

In one embodiment, the universal switching signal may transition between the first and the second voltage levels over a time in excess of 50 ms or in excess of 100 ms. In one embodiment the transition time is in the range of 100-1000 ms.

In one embodiment the voltage level of the switching signal changes smoothly between the first and the second voltage levels (e.g. with the switching signal passing in a continuous manner through a plurality of intermediate voltage levels as it changes between the first and second voltage levels). The switching signal may however be discontinuous outside of the range of the first and the second voltage levels.

In one embodiment, the signal generator may include a square-wave generator and a waveform-shaping filter. This has the advantage that the same circuit provides both a signal for use by the switching arrangements and a clock signal for use by the control stages.

In one embodiment, the signal generator further provides the complement of the universal switching signal (e.g. to allow switching on or off to be selected at any instant).

Typically, each switching arrangement has a respective pass gate is provided that can be operated, under the control of the control stage, to connect either the switching signal or the steady signal to the switching stage.

The control stage of each of the first and second switching arrangements is configured to cause the switching stage to change between its first and its second states in response to control logic. However, this control logic does not directly effect the change, so can, for example, be a binary on/off signal that might otherwise give rise to transients in the output. The profile of the change in the output signal is determined entirely by the characteristics of the switching signal.

In one embodiment, each switching stage functions as a voltage-controlled resistor (e.g. having a resistance that changes (e.g. monotonically) with voltage). In such a case, it may be configured to have a low-resistance when the switching stage is in the second state, thereby connecting the signal input to a ground or a reference voltage.

In one embodiment, the outputs of the first and second switching arrangements are connected together to form a multiple signal mixer or multiplexor. Such a circuit can operate to mute all signals, or to connect one or more signals from the input to the output - that is, as a channel mixer or a channel multiplexor.

In accordance with a second aspect of the present invention, there is provided a method of switching a signal in a circuit (e.g. audio circuit), the circuit including: first and second switching arrangements, each switching arrangement having a signal input, a signal output, a control stage, and a switching stage having a control input, each switching stage operating to pass a signal from the signal input to the signal output at a level that varies from muted to a high level as a voltage appearing on the control input varies between first and second voltage levels; and a signal generator that generates a universal switching signal that transitions between the first and the second voltage levels, wherein the universal switching signal transitions between the first and the second voltage levels in a period of time that causes each switching stage to change state at a rate that is sufficiently slow as to prevent audible transients appearing on the signal output; the method comprising for each of the first and second switching arrangements: operating in a steady mode to retain the switching stage in one or other of the muted or the high level by applying to its control input a steady signal at the first or the second level; and, in a transition mode, applying the universal switching signal generated by the signal generator to the control input of the switching stage to cause the voltage appearing on the control input to transition between one and the other of the first and the second levels; wherein the method further comprises varying operation of the first and second switching stages between the muted and high levels by applying to the control stages of the first and second switching stages control logic specific to each respective switching arrangement; characterised in that the universal switching signal is an oscillating signal continuously supplied to the control stage of each of the first and second switching arrangements with the control logic determining when the switching stage of each of the first and second switching arrangements changes between the muted and high levels using the universal switching signal to effect the change.

By suitable timing of the change in mode of operation, the occurrence of sudden changes in the voltage appearing on the control input can be minimised, thereby reducing the likelihood of audible transients appearing on the output.

Typically, in the transient mode, the transition of the voltage appearing on the control input of the switching stages occurs over a time being in the order of 100-1000 ms.

An embodiments of the present invention will now be described by way of example with reference to the accompanying drawings in which:
Figure 1 shows a known arrangement of an operational amplifier configured to sum input signals,
Figure 2 shows a modification to the circuit of Figure 1 that can select from a plurality of inputs to be passed to an output;
Figure 3 shows a circuit for switching a single signal;
Figure 4 illustrates the conductive properties of a conventional pass gate and a voltage-controlled resistor, as used in embodiments of the invention;
Figure 5 shows control signal wave forms used in the control of embodiments of the invention; and
Figure 6 shows a circuit in accordance with an embodiment of the present invention for switching or multiplexing two signals.

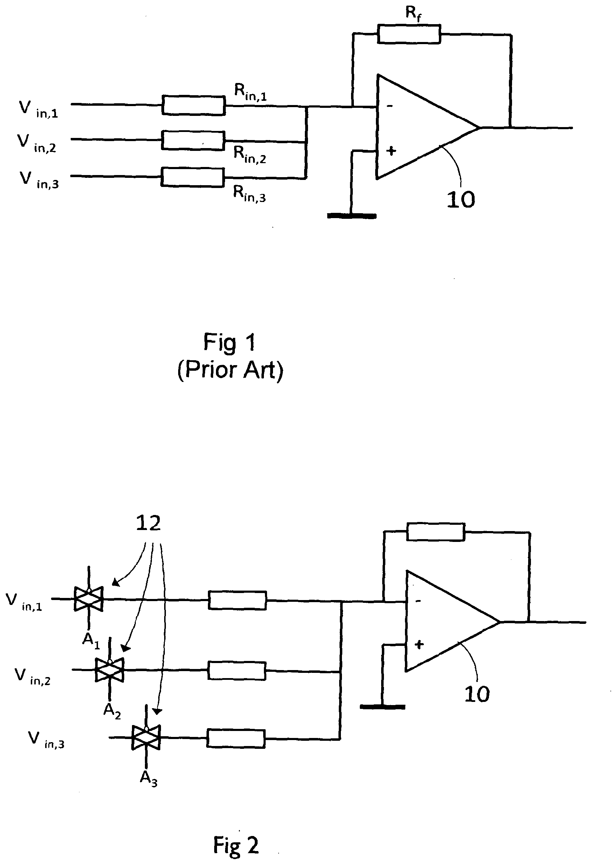

Figure 1 shows one known arrangement that may be considered a starting point for implementing signal switching in accordance with the invention. In this arrangement, an operational amplifier 10 is configured as a summing amplifier. In this example, three independent audio signals Vin,1, Vin,2, Vin,3 are summed together. The scheme of Figure 1 is readily extended to accept an arbitrarily large number of independent signals.

This circuit can be adapted, as shown in Figure 2, to function as a multiplexor that can select 0, 1 or more of n input signals to be passed to an output. In this circuit, each input signal Vin,1, Vin,2, Vin,3 is switched by a respective pass gate 12 each controlled by a respective switching signal A1, A2, A3 which, depending upon the particular implementation of the pass gate, may be a single logic signal or a pair of complementary signals. The speed at which the pass gates 12 operate (that is, the speed with which they change from a low-resistance to a high-resistance state) and the presence of any DC offset in the system will determine whether electronic transients, which may be heard as unwanted clicks and pops, will be generated.

A typical pass gate or "analogue switch" is designed such that there is, as near as possible an immediate transition between two distinct states (conducting or not-conducting) associated with the two allowed Boolean states of the input (asserted or not-asserted). This is likely to cause transients in the output of the circuit of Figure 2. Therefore, in moving towards the present invention, the inventors have adapted the circuit of Figure 2 by using a modified circuit in place of the pass gate.

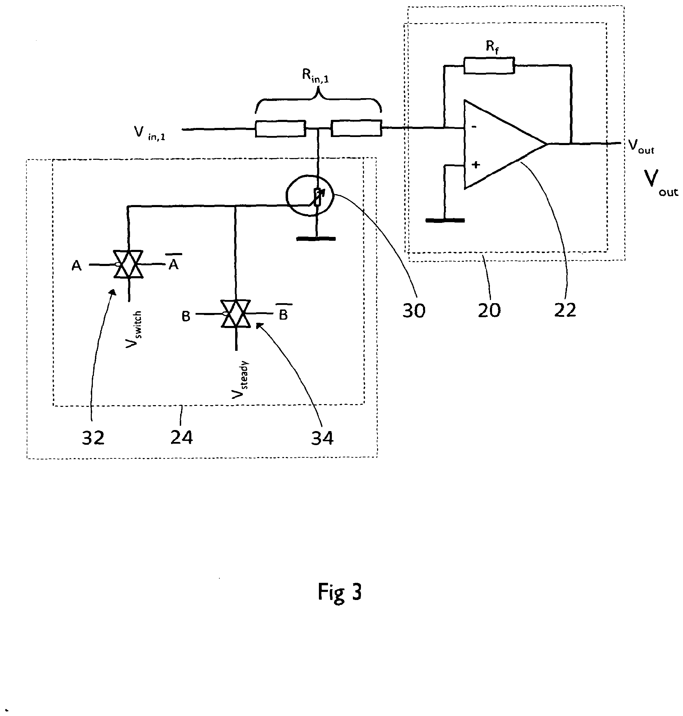

An illustration of a circuit for implementing a soft switch for one signal is shown in Figure 3.

The circuit of Figure 3 takes an input Vin,1 and provides an output Vout. The input Vin,1 is connected through a series resistance Rin,1 to an amplification stage 20 that uses a conventionally connected operational amplifier 22. The non-inverting input of the operational amplifier 22 is connected to a ground plane or other reference voltage, as the case may be. The circuit of Figure 3 additionally includes a switching arrangement 24 including: a switching stage in the form of a voltage-controlled resistor (VCR) 30; and a control stage comprising a first pass gate 32 and a second pass gate 34. The VCR 30 has a conductive path connected between the series resistance Rin,1 and the ground plane or other reference voltage. (Note that the series resistance Rin,1 may be implemented as a length of conductive track on a substrate, with the VCR being connected part way along the track, so that the series resistance Rin,1 is shown diagrammatically as two series-connected resistors.) A control input of the VCR 30 is connected to outputs of each of the first and the second pass gate 32, 34. The first pass gate 32 receives complementary switching signals A, A⁻ and the second pass gate 34 receives complementary switching signals B, B⁻. An input of the first pass gate 32 is connected to a switching signal Vswitch, and an input of the second pass gate 34 is connected to a steady signal Vsteady.

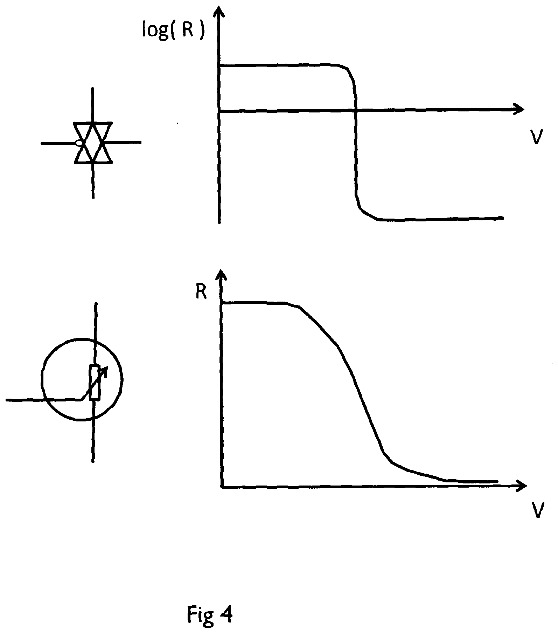

The VCR 30 has a wide switching range. As shown in the lower graph of Figure 4, the input to output resistance R changes from a high-resistance state to a low-resistance state as the voltage V on its control input increases over a range of values, as compared with the sudden change of a typical pass gate, shown in the upper graph of Figure 4.

When this VCR 30 is in its high-resistance state, its presence does not influence the circuit; the input signal Vin,1 is passed to the amplification stage. When the VCR 30 is in its low-resistance state, it clamps the input to ground (or the voltage reference point), thereby effectively muting the signal.

Note that the resistance values in the circuit of Figure 3 are chosen to be commensurate with the range of resistances implemented by the VCR 30. In practice, these will provide "on" resistances in the low-resistance state of O(10Ω), so the resistances are chosen to give acceptable attenuation in the muted state with this "on" resistance. The "off resistance in the high-resistance state of O(10⁶Ω), imposing little limitation on ordinary analogue design.

In the above arrangement, if the control signals applied to the voltage applied to the control input of the VCR 30 were changed overly quickly, it would still be capable of generating transients leading to audible clicks and pops on the output. Therefore, the control voltages applied to the control input of the VCR are managed to avoid such quick state changes.

The control voltages applied to the VCR 30 are managed in two parts. Each of these parts conveniently is associated with a respective one of the first and second pass gates 32, 34. There is a functional split between the two aspects of controlling i) transition phases and ii) steady-state phases. These phases are associated with the first and second pass gates 32, 34.

The first pass gate 32 is used to manage the switching transitions of the VCR, which are made by the application of one half period of a globally available waveform Vswitch. This waveform makes repeated transitions between control voltage magnitudes associated with the fully conducting, low-resistance state of the VCR 30 and the high-resistance, fully closed state. It is the responsibility of a controlling logic system to identify the sense of the required transition (open to closed or closed to open) and to identify which of the two half cycles of Vswitch should be applied to the control input to effect the required transition. It is further the responsibility of a controlling logic system to wait until the appropriate instant of time when that half cycle commences - at this instant, the VCR 30 can be taken through the intended transition.

The second pass gate 34 is used to hold the intended operating state of the VCR 30 for long-term, steady-state operation. This second pass gate is used to switch a Boolean control voltage, Vsteady, to the VCR. The two defined states of this control voltage also are associated with the fully conducting state of the VCR and the fully "closed" state and, therefore, coincide intentionally with the extreme values of Vswitch. It is the responsibility of a control logic system to ensure that the controlling inputs to the pass gates are mutually exclusive (that is, A.B=0) and to provide the appropriate steady-state control voltage for the VCR, Vsteady.

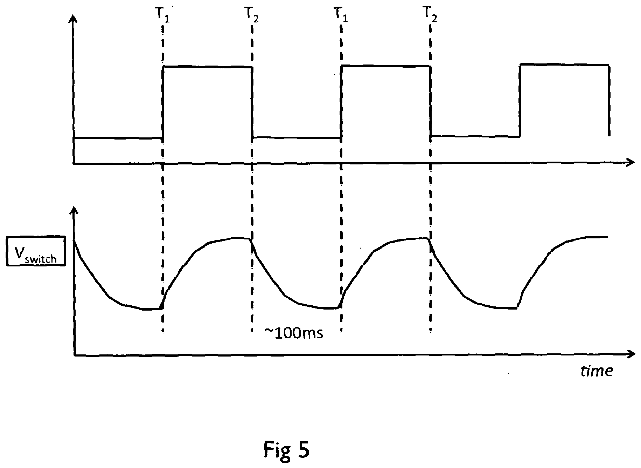

The switching waveform, Vswitch, in this example, is generated by subjecting a square wave signal to a low-pass filtering operation, as illustrated in Figure 5. This operation is conveniently achieved by a simple filter, which can be realized as a single resistor and capacitor network, in a manner that will be readily understood by those skilled in the technical field. The envelope of the switching waveform Vswitch, with its slow rates of change of voltage with respect to time, is responsible for the prevention of transients arising from the operation of the switches - accordingly, the period of the generating square wave and the time constant of the low-pass filter must be selected to give an appropriate signal. These can be easily determined by experiment, a switching time between the two extreme voltages of the order of hundreds of milliseconds O(10⁻¹s) is typically appropriate. Operation of the control logic system will now be described.

Assume the convention (as implied by Figure 4) that the pass gates 32, 34 and the VCR 30 require a positive control input to switch "on" (that is, go into a low-resistance state) and zero voltage to switch "off' (that is, go into a high-resistance state). The Boolean control variables for the first and second pass gates 32, 34 are, respectively, A and B, as shown in Figure 3.

On receipt of a request to switch the VCR 30 of Figure 3 into a low-resistance state (thereby muting the audio input), the control logic must, with reference to Figure 5:
wait until time T1;
turn on the first pass gate 32 (A=1) and turn off the second pass gate 34 (B=0);
assert the steady state control (Vsteady = 1) (note: the second pass gate 34 is off at this point and the switching waveform is applied via the first pass gate 32 to the control input of the VCR);
wait until time T2; and
turn off the first pass gate 32 (A=0) and turn on the second pass gate 34 (B=1).
The input is now muted and the logic simply maintains Vsteady = 1 and B = 1 until the switch is to be changed again.

The description above has been simplified for clarity. In practice, the precise timing of the steps within 2 and 5 and the actions at 1 and 4 is important to ensure that no sudden changes to the voltage on the control input for the VCR 30 occur.

On receipt of a request to switch the VCR 30 of Figure 3 into its high-resistance state (thereby enabling the audio input), the control logic must:
wait until time T2;
turn on the first pass gate 32 (A = 1) and turn off the second pass gate 34 (B = 0);
assert the steady state control (Vsteady = 0) (note: the steady-state pass gate is off at this point and the switching waveform is again applied to the control input of the VCR);
wait until T1;
turn off the first pass gate 32 (A = 0) and turn on the steady-state pass gate 34 (B=1)

The input is now un-muted and the logic simply maintains Vsteady = 0 and B = 1 until the switch is to be changed again.

The similarity between the procedures for the two transitions leads to efficiency in the design and implementation of the control logic.

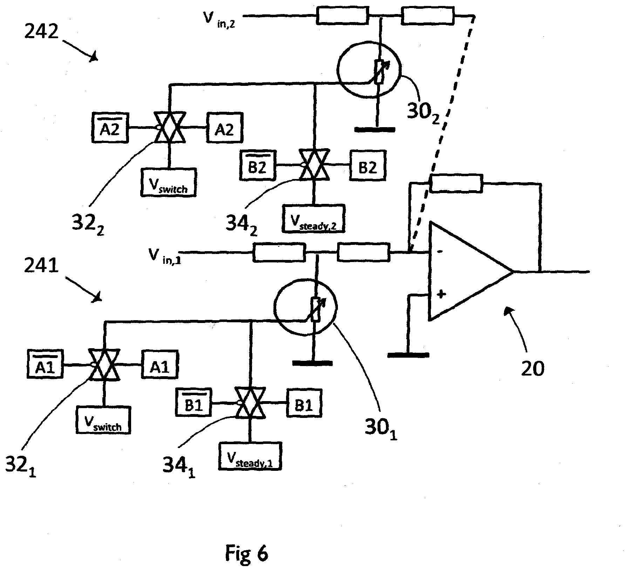

Figure 6 shows a summing amplifier with two audio inputs in accordance with an embodiment of the present invention. Each input is to a respective switching arrangement 241, 242 that is similar to the switching arrangement described above with reference to Figure 3. The circuit of Figure 6 has two signal inputs Vin,1 and Vin,2 that are connected to the respective switching stages 241, 242. The output of each of the switching arrangements 241, 242 is connected to the input of a common amplification stage 20, again, similar to that described with reference to Figure 3. This allows the individual inputs Vin,1 and Vin,2 to be enabled or muted independently.

In general, the circuit could have n inputs being identified by an index i. Each input Vin,i has associated Boolean control variables Ai, Bi and Vsteady,i (and, if required, their complements). However, the analogue switching waveform Vswitch is a universal switching waveform formed by a single signal generator and shared between the inputs (and the inputs of any other switching stages forming part of the circuit). As shown in Figure 6, the system can mute or enable both switches simultaneously. If, however, the switches were required to make opposite transitions (one input muting, the other opening or vice versa), one transition would have to be made in one half cycle of Vswitch and the other in the subsequent half cycle. In such an embodiment, the maximum switching latency of the entire scheme would be 3T/2, where T is the period of the switching waveform Vswitch.

In embodiments that require complementary control signals, it has already been noted it may be desirable to distribute not only the waveform Vswitch but also its complement. In such cases, it is possible to modify the controlling logic to exploit the fact that there is a positive-going and a negative-going transition of the switching waveform available every half cycle, such that the maximum switching latency of the entire scheme would be T.

Advantageously, the provision of a universal switching waveform can result in a significant reduction in the number of components required to provide implement the switching circuits.

## Claims

1. A circuit comprising:
first and second switching arrangements (241, 242), each switching arrangement (241, 242) comprising:
a signal input (V_{in,1})(V_{in,2});
a signal output;
a switching stage (30₁)(30₂) that has a control input, the switching stage (30₁)(30₂) being operative, in response to a control signal applied to the control input changing between a first voltage level and a second voltage level, to change between a first state in which it causes a signal on the signal input (V_{in,1})(V_{in,2}) to pass to the signal output and a second state in which the signal output is muted; and
a control stage (32₁, 34₁) (32₂, 34₂) that operates: in a steady mode to apply a steady signal to the control input of the switching stage (30₁)(30₂) at one or other of the first or the second voltage level to cause the switching stage to be maintained in its first or its second state as required; and in a switching mode to apply a universal switching signal that transitions between the first voltage level and the second voltage level to the control input of the switching stage (30₁)(30₂) to cause the switching stage to transition between its first and its second state; and
the circuit further comprising a signal generator configured to provide the universal switching signal to each of the first and second switching arrangements (241, 242), wherein the control stage (32₁, 34₁) (32₂, 34₂) of each of the first and second switching arrangements (241, 242) is further configured to cause its respective switching stage (30₁)(30₂) to change between its first and its second states in response to control logic specific to each respective switching arrangement (241, 242), wherein the universal switching signal transitions between the first and the second voltage levels in a period of time that causes each switching stage (30₁)(30₂) to change state at a rate that is sufficiently slow as to prevent audible transients appearing on the signal output;
**characterised in that** the universal switching signal is an oscillating signal continuously supplied to the control stage of each of the first and second switching arrangements (241, 242) with the control logic determining when the switching stage (30₁)(30₂) of each of the first and second switching arrangements (241, 242) changes between its first and second states using the universal switching signal to effect the change.

2. A circuit according to claim 1, wherein the voltage of the universal switching signal changes smoothly between the first and the second voltage levels.

3. A circuit according to any of the preceding claims, wherein each switching stage (30₁)(30₂) functions as a voltage-controlled resistor.

4. A circuit according to claim 1, wherein each control stage (32₁, 34₁) (32₂, 34₂) is configured to connect the signal input (V_{in,1})(V_{in,2}) to a ground or a reference voltage when its respective switching stage (30₁)(30₂) is in the second state.

5. A circuit according to any preceding claim, wherein the signal generator further provides the complement of the universal switching signal.

6. A circuit according to any of the preceding claims, wherein the signal generator includes a square-wave generator and a waveform-shaping filter, whereby the same circuit provides both the universal switching signal for use by the switching arrangements (241, 242) and a clock signal for use by the control stages (32₁, 34₁) (32₂, 34₂).

7. A method of switching a signal in a circuit, the circuit including:
first and second switching arrangements (241, 242), each switching arrangement (241, 242) having a signal input (V_{in,1})(V_{in,2}), a signal output, a control stage, and a switching stage (30₁)(30₂) having a control input, each switching stage (30₁)(30₂) operating to pass a signal from the signal input to the signal output at a level that varies from muted to a high level as a voltage appearing on the control input varies between first and second voltage levels; and
a signal generator that generates a universal switching signal that transitions between the first and the second voltage levels, wherein the universal switching signal transitions between the first and the second voltage levels in a period of time that causes each switching stage (30₁)(30₂) to change state at a rate that is sufficiently slow as to prevent audible transients appearing on the signal output;
the method comprising for each of the first and second switching arrangements (241, 242): operating in a steady mode to retain the switching stage (30₁)(30₂) in one or other of the muted or the high level by applying to its control input a steady signal at the first or the second level; and, in a transition mode, applying the universal switching signal generated by the signal generator to the control input of the switching stage (30₁)(30₂) to cause the voltage appearing on the control input to transition between one and the other of the first and the second levels, wherein the method further comprises varying operation of the first and second switching stages (30₁)(30₂) between the muted and high levels by applying to the control stages of the first and second switching stages (30₁)(30₂) control logic specific to each respective switching arrangement (241, 242);
**characterised in that** the universal switching signal is an oscillating signal continuously supplied to the control stage of each of the first and second switching arrangements (241, 242) with the control logic determining when the switching stage (30₁)(30₂) of each of the first and second switching arrangements (241, 242) changes between the muted and high levels using the universal switching signal to effect the change.

8. A method according to claim 7, wherein the signal generator further provides the complement of the universal switching signal.

9. A method according to claim 7 or claim 8, wherein the signal generator includes a square-wave generator and a waveform-shaping filter, whereby the same circuit provides both the universal switching signal for use by the switching stages (30₁)(30₂) and a clock signal used by the control stages (32₁, 34₁) (32₂, 34₂).

## Patentansprüche

1. Schaltung, umfassend:
erste und zweite Schaltanordnungen (241, 242), wobei jede Schaltanordnung (241, 242) folgendes umfasst:
einen Signaleingang (V_{in,1})(V_{in,2});
einen Signalausgang;
eine Schaltstufe (30₁)(30₂), die einen Steuereingang aufweist, wobei die Schaltstufe (30₁)(30₂) als Reaktion auf einen Wechsel eines Steuersignal, das dem Steuereingang zugeführt wird, zwischen einem ersten Spannungswert und einem zweiten Spannungswert so funktionsfähig ist, dass sie zwischen einem ersten Zustand, in dem sie bewirkt, dass ein Signal an dem Signaleingang (V_{in,1})(V_{in,2}) zu dem Signalausgang verläuft, und einem zweiten Zustand, in dem der Signalausgang ausgeschaltet ist, wechselt; und
eine Steuerstufe (32₁, 34₁) (32₂, 34₂), die wie folgt arbeitet: in einem festen Modus, um ein festes Signal dem Steuereingang der Schaltstufe (30₁)(30₂) auf dem einen oder dem anderen Wert des ersten oder zweiten Spannungswerts zuzuführen, um zu bewirken, dass die Schaltstufe nach Bedarf in ihrem ersten oder zweiten Zustand gehalten wird; und in einem Schaltmodus, um ein universelles Schaltsignal, das zwischen dem ersten Spannungswert und dem zweiten Spannungswert übergeht, dem Steuereingang der Schaltstufe (30₁)(30₂) zuzuführen, um zu bewirken, dass die Schaltstufe zwischen ihrem ersten und ihrem zweiten Zustand übergeht; und
wobei die Schaltung ferner einen Signalgenerator umfasst, der so gestaltet ist, dass er das universelle Schaltsignal an jede der ersten und zweiten Schaltanordnungen (241, 242) bereitstellt, wobei die Steuerstufe (32₁, 34₁) (32₂, 34₂) jeder der ersten und zweiten Schaltanordnungen (241, 242) ferner so gestaltet ist, dass sie bewirkt, dass ihre entsprechende Schaltstufe (30₁)(30₂) zwischen ihren ersten und zweiten Zuständen als Reaktion auf eine für jede entsprechende Schaltanordnung (241, 242) spezifische Steuerlogik wechselt, wobei das universelle Schaltsignal in einem Zeitraum zwischen den ersten und zweiten Spannungswerten übergeht, der bewirkt, dass jede Schaltstufe (30₁)(30₂) ihren Zustand mit einer Geschwindigkeit ändert, die ausreichend langsam ist, um es zu verhindern, dass an dem Signalausgang hörbare Übergänge auftreten;
**dadurch gekennzeichnet, dass** das universelle Schaltsignal ein oszillierendes Signal ist, das kontinuierlich der Steuerstufe jeder der ersten und zweiten Schaltanordnungen (241, 242) zugeführt wird, wobei die Steuerlogik bestimmt, wann die Schaltstufe (30₁)(30₂) jeder der ersten und zweiten Schaltanordnungen (241, 242) zwischen ihren ersten und zweiten Zuständen wechselt, unter Verwendung des universellen Schaltsignals zum Bewirken des Wechsels.

2. Schaltung nach Anspruch 1, wobei sich die Spannung des universellen Schaltsignals zwischen den ersten und zweiten Spannungswerten nahtlos ändert.

3. Schaltung nach einem der vorstehenden Ansprüche, wobei jede Schaltstufe (30₁)(30₂) als ein spannungsgesteuerter Widerstand arbeitet.

4. Schaltung nach Anspruch 1, wobei jede Steuerstufe (32₁, 34₁) (32₂, 34₂) so gestaltet ist, dass sie den Signaleingang (V_{in,1})(V_{in,2}) mit einer Masse oder einer Referenzspannung verbindet, wenn sich die entsprechende Schaltstufe (30₁)(30₂) in dem zweiten Zustand befindet.

5. Schaltung nach einem der vorstehenden Ansprüche, wobei der Signalgenerator ferner das Komplement des universellen Schaltsignals bereitstellt.

6. Schaltung nach einem der vorstehenden Ansprüche, wobei der Signalgenerator einen Rechteckwellengenerator und einen Wellenformungsfilter umfasst, wobei die gleiche Schaltung sowohl das universelle Schaltsignal zur Verwendung durch die Schaltanordnungen (241, 242) als auch ein Taktsignal zur Verwendung durch die Steuerstufen (32₁, 34₁) (32₂, 34₂) bereitstellt.

7. Verfahren zum Umschalten eines Signals in einer Schaltung, wobei die Schaltung folgendes umfasst:
erste und zweite Schaltanordnungen (241, 242), wobei jede Schaltanordnung (241, 242) folgendes umfasst: einen Signaleingang (V_{in,1})(V_{in,2}), einen Signalausgang, eine Steuerstufe und eine Schaltstufe (30₁)(30₂) mit einem Steuereingang, wobei jede Schaltstufe (30₁)(30₂) so arbeitet, dass sie ein Signal von dem Signaleingang zu dem Signalausgang mit einem Wert leitet, der zwischen ausgeschaltet und einem hohen Wert variiert, entsprechend der Veränderung einer an dem Steuereingang auftretenden Spannung zwischen ersten und zweiten Spannungswerten; und
einen Signalgenerator, der ein universelles Schaltsignal erzeugt, das zwischen den ersten und zweiten Spannungswerten übergeht, wobei das universtelle Schaltsignal in einem Zeitraum zwischen den ersten und zweiten Spannungswerten übergeht, der bewirkt, dass die Schaltstufe (30₁)(30₂) ihren Zustand mit einer Geschwindigkeit ändert, die ausreichend langsam ist, um es zu verhindern, dass an dem Signalausgang hörbare Übergänge auftreten;
wobei das Verfahren für jede der ersten und zweiten Schaltanordnungen (241, 242) folgendes umfasst: Betrieb in einem festen Modus, um die Schaltstufe (30₁)(30₂) auf dem einen oder dem anderen Wert des ausgeschalteten oder des hohen Werts zu halten, indem ihrem Steuereingang ein festes Signal auf dem einen oder dem anderen Wert zugeführt wird; und in einem Übergangsmodus, Zuführen des durch den Signalgenerator erzeugten universellen Schaltsignals an den Steuereingang der Schaltstufe (30₁)(30₂), um zu bewirken, dass die an dem Steuereingang auftretende Spannung zwischen dem einen und dem anderen der ersten und zweiten Werte übergeht, wobei das Verfahren ferner das Ändern des Betriebs der ersten und zweiten Schaltstufe (30₁)(30₂) zwischen dem ausgeschalteten und dem hohen Wert umfasst, durch Anwenden einer für jede entsprechende Schaltanordnung (241, 242) spezifischen Steuerlogik auf die Steuerstufen der ersten und zweiten Schaltstufe (30₁)(30₂);
**dadurch gekennzeichnet, dass** das universelle Schaltsignal ein oszillierendes Signal ist, das kontinuierlich der Steuerstufe jeder der ersten und zweiten Schaltanordnungen (241, 242) zugeführt wird, wobei die Steuerlogik bestimmt, wann die Schaltstufe (30₁)(30₂) jeder der ersten und zweiten Schaltanordnungen (241, 242) zwischen den ausgeschalteten und hohen Werten wechselt, unter Verwendung des universellen Schaltsignals zum Bewirken des Wechsels.

8. Verfahren nach Anspruch 7, wobei der Signalgenerator ferner das Komplement des universellen Schaltsignals bereitstellt.

9. Verfahren nach Anspruch 7 oder Anspruch 7, wobei der Signalgenerator einen Rechteckwellengenerator und einen Wellenformungsfilter umfasst, wobei die gleiche Schaltung sowohl das universelle Schaltsignal zur Verwendung durch die Schaltstufen (30₁)(30₂) als auch ein Taktsignal zur Verwendung durch die Steuerstufen (32₁, 34₁) (32₂, 34₂) bereitstellt.

## Revendications

1. Circuit, comprenant :
des premier et second dispositifs de commutation (241, 242), chaque dispositif de commutation (241, 242) comprenant :
une entrée de signal (V_{in,1})(V_{in,2});
une sortie de signal ;
un étage de commutation (30₁)(30₂) qui a une entrée de commande, l'étage de commutation (30₁)(30₂) fonctionnant, en réponse à un signal de commande appliqué à l'entrée de commande changeant entre un premier niveau de tension et un second niveau de tension, pour changer entre un premier état dans lequel il amène un signal sur l'entrée de signal (V_{in,1})(V_{in,2}) à passer à la sortie de signal et un second état dans lequel la sortie de signal est rendue silencieuse ; et
un étage de commande (32₁, 34₁) (32₂, 34₂) qui fonctionne : en mode permanent pour appliquer un signal permanent à l'entrée de commande de l'étage de commutation (30₁)(30₂) à l'un ou l'autre du premier ou du second niveau de tension pour amener l'étage de commutation à être maintenu dans son premier ou son second état selon les besoins ; et en mode de commutation pour appliquer un signal de commutation universel qui effectue une transition entre le premier niveau de tension et le second niveau de tension à l'entrée de commande de l'étage de commutation (30₁)(30₂) pour amener l'étage de commutation à faire la transition entre son premier et son second état ; et
le circuit comprenant en outre un générateur de signal conçu pour fournir le signal de commutation universel à chacun des premier et second dispositifs de commutation (241, 242), l'étage de commande (32₁, 34₁) (32₂, 34₂) de chacun des premier et second dispositifs de commutation (241, 242) étant en outre conçu pour amener son étage de commutation (30₁)(30₂) respectif à changer entre son premier et son second état en réponse à une logique de commande spécifique à chaque dispositif de commutation (241, 242) respectif, le signal de commutation universel effectuant une transition entre le premier et le second niveau de tension dans une période de temps qui amène chaque étage de commutation (30₁)(30₂) à changer d'état à une vitesse qui est suffisamment lente pour empêcher des transitoires audibles d'apparaître sur la sortie de signal ;
**caractérisé en ce que** le signal de commutation universel est un signal oscillant fourni en continu à l'étage de commande de chacun des premier et second dispositifs de commutation (241, 242), la logique de commande déterminant le moment où l'étage de commutation (30₁)(30₂) de chacun des premier et second dispositifs de commutation (241, 242) change entre ses premier et second états en utilisant le signal de commutation universel pour effectuer le changement.

2. Circuit selon la revendication 1, la tension du signal de commutation universel changeant de façon régulière entre le premier et le second niveau de tension.

3. Circuit selon l'une quelconque des revendications précédentes, chaque étage de commutation (30₁)(30₂) fonctionnant comme une résistance commandée en tension.

4. Circuit selon la revendication 1, chaque étage de commande (32₁, 34₁) (32₂, 34₂) étant conçu pour connecter l'entrée de signal (V_{in,1})(V_{in,2}) à une masse ou à une tension de référence lorsque son étage de commutation (30₁)(30₂) respectif est dans le second état.

5. Circuit selon l'une quelconque des revendications précédentes, le générateur de signal fournissant en outre le complément du signal de commutation universel.

6. Circuit selon l'une quelconque des revendications précédentes, le générateur de signal comprenant un générateur d'ondes carrées et un filtre de mise en forme d'ondes, le même circuit fournissant à la fois le signal de commutation universel destiné à être utilisé par les dispositifs de commutation (241, 242) et un signal d'horloge destiné à être utilisé par les étages de commande (32₁, 34₁) (32₂, 34₂).

7. Procédé de commutation d'un signal dans un circuit, le circuit comprenant :
des premier et second dispositifs de commutation (241, 242), chaque dispositif de commutation (241, 242) ayant une entrée de signal (V_{in,1})(V_{in,2}), une sortie de signal, un étage de commande, et un étage de commutation (30₁)(30₂) ayant une entrée de commande, chaque étage de commutation (30₁)(30₂) fonctionnant pour faire passer un signal de l'entrée de signal à la sortie de signal à un niveau qui varie de muet à un niveau élevé lorsqu'une tension apparaissant sur l'entrée de commande varie entre des premier et second niveaux de tension ; et
un générateur de signal qui génère un signal de commutation universel qui effectue une transition entre les premier et second niveaux de tension, le signal de commutation universel effectuant une transition entre les premier et second niveaux de tension dans une période de temps qui amène chaque étage de commutation (30₁)(30₂) à changer d'état à un rythme suffisamment lent pour empêcher l'apparition de transitoires audibles sur la sortie de signal ;
le procédé comprenant, pour chacun des premier et second dispositifs de commutation (241, 242), les étapes consistant à : fonctionner en mode permanent pour maintenir l'étage de commutation (30₁)(30₂) dans l'un ou l'autre des niveaux muet ou élevé en appliquant à son entrée de commande un signal permanent au premier ou au second niveau ; et, dans un mode de transition, appliquer le signal de commutation universel généré par le générateur de signal à l'entrée de commande de l'étage de commutation (30₁)(30₂) pour amener la tension apparaissant sur l'entrée de commande à effectuer la transition entre l'un et l'autre des premier et second niveaux, le procédé comprenant en outre l'étape consistant à faire varier le fonctionnement des premier et second étages de commutation (30₁)(30₂) entre les niveaux muet et élevé en appliquant aux étages de commande des premier et second étages de commutation (30₁)(30₂) une logique de commande spécifique à chaque dispositif de commutation (241, 242) respectif ;
**caractérisé en ce que** le signal de commutation universel est un signal oscillant fourni en continu à l'étage de commande de chacun des premier et second dispositifs de commutation (241, 242), la logique de commande déterminant quand l'étage de commutation (30₁)(30₂) de chacun des premier et second dispositifs de commutation (241, 242) change entre les niveaux muet et élevé en utilisant le signal de commutation universel pour effectuer le changement.

8. Procédé selon la revendication 7, le générateur de signal fournissant en outre le complément du signal de commutation universel.

9. Procédé selon la revendication 7 ou 8, le générateur de signal comprenant un générateur d'ondes carrées et un filtre de mise en forme d'onde, le même circuit fournissant à la fois le signal de commutation universel destiné à être utilisé par les étages de commutation (30₁)(30₂) et un signal d'horloge utilisé par les étages de commande (32₁, 34₁) (32₂, 34₂).
